# EUROPEAN PATENT APPLICATION

(11) **EP 4 756 870 A1**
(43) Date of publication of application: **10.06.2026**
(21) Application number: 24848975.9
(22) Date of filing: 22.07.2024
(51) Int. Cl.: H01L 23/15, H01L 23/13, H05K 1/03, H05K 1/09, H05K 1/11

(54) **WIRING BOARD, ELECTRONIC DEVICE, AND ELECTRONIC MODULE**

(30) Priority: 31.07.2023 JP 2023124016
(71) Applicant: Kyocera Corporation, Kyoto-shi, Kyoto 612-8501 (JP)
(72) Inventor: TAKESHIMA, Yuki, Kyoto-shi, Kyoto 612-8501 (JP); HOSOI, Yoshihiro, Kyoto-shi, Kyoto 612-8501 (JP); KAMASE, Yuji, Kyoto-shi, Kyoto 612-8501 (JP)
(74) Representative: Viering, Jentschura & Partner mbB Patent- und Rechtsanwälte
(86) International application number: PCT/JP2024/026125
(87) International publication number: WO 2025/028320

(57) **Abstract**

A wiring board (1) includes an insulating substrate (10) containing aluminum nitride as a main component and including a plurality of particles (15) bonded together, a titanium oxide layer (31) located on a surface of the insulating substrate, and a conductor layer (32, 33) located on the titanium oxide layer. The surface of the insulating substate includes irregularities caused by shapes and arrangement of the particles. The titanium oxide layer covers the irregularities.

## Description

### TECHNICAL FIELD

The present disclosure relates to a wiring board, an electronic device, and an electronic module.

### BACKGROUND OF INVENTION

A known wiring board includes an insulating substrate over which a conductor layer made of metal is provided (refer to Patent Literature 1, for example).

### CITATION LIST

### PATENT LITERATURE

Patent Literature 1: Japanese Unexamined Patent Application Publication No. 2018-125344

### SUMMARY

In an embodiment of the present disclosure, a wiring board includes an insulating substrate containing aluminum nitride as a main component and including a plurality of particles bonded together, a titanium oxide layer located on a surface of the insulating substrate, and a conductor layer located on the titanium oxide layer. The surface of the insulating substrate includes irregularities caused by shapes and arrangement of the particles. The titanium oxide layer covers the irregularities.

In an embodiment of the present disclosure, an electronic device includes the above-described wiring board and an electronic component mounted on the wiring board.

In an embodiment of the present disclosure, an electronic module includes the above-described electronic device and a module substrate on which the electronic device is mounted.

### BRIEF DESCRIPTION OF THE DRAWINGS

FIG. 1 is a perspective view of a wiring board according to an embodiment of the present disclosure.
FIG. 2 is a sectional view of an essential part of the wiring board of FIG. 1.
FIG. 3 is a diagram illustrating a method of measuring sizes of metal crystal grains.
FIG. 4 is a sectional view illustrating a surface portion of the wiring board.
FIG. 5 is a sectional view illustrating a surface portion of the wiring board.
FIG. 6 is a sectional view of a variation of a through portion.
FIG. 7 is a sectional view of another variation of the through portion.
FIG. 8 is a sectional view of another variation of the through portion.
FIG. 9 is a diagram illustrating an electronic device and an electronic module according to an embodiment of the present disclosure.

### DESCRIPTION OF EMBODIMENTS

An embodiment of the present disclosure will be described in detail below with reference to the drawings. In a wiring board, a defective portion such as a void located in conductor layers may cause a conduction failure. The present disclosure aims to reduce occurrence of defects in a wiring board.

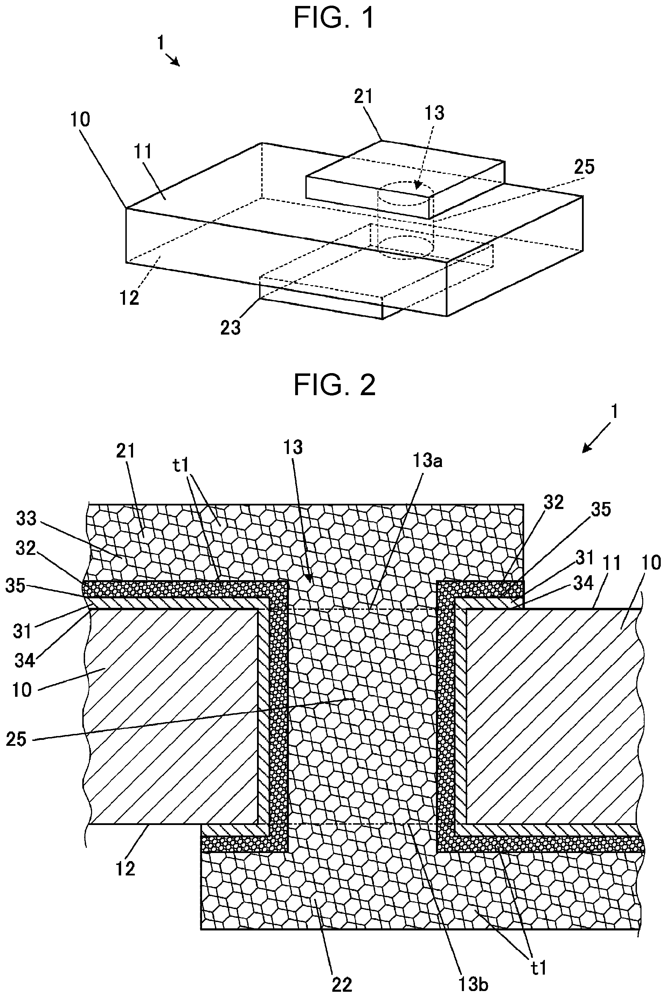

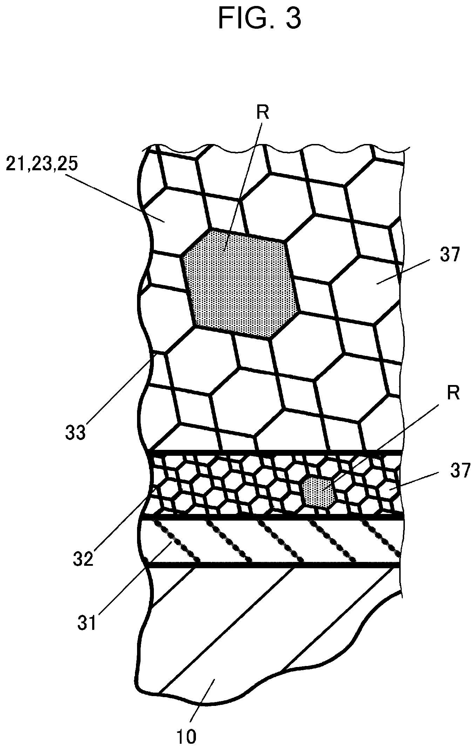

FIG. 1 is a perspective view of a wiring board 1 according to an embodiment of the present disclosure. FIG. 2 is a sectional view of an essential part of the wiring board 1 of FIG. 1. FIG. 3 is a diagram illustrating a section of a portion of the wiring board 1 in which a wiring conductor is located.

In the following description, the term "perpendicular" refers not only to a state that is exactly perpendicular but also to a state that may be regarded as substantially perpendicular. The "state that may be regarded as substantially perpendicular" is intended not to be limited to a state within manufacturing tolerances, but may also include, for example, a state in which an angle formed between two directions is close to 90 degrees. More specifically, the angle may be equal to or greater than 80 degrees and less than 90 degrees, may be equal to or greater than 85 degrees and less than 90 degrees, or may be equal to or greater than 88 degrees and less than 90 degrees. Additionally, a numerical range "from X to Y" is intended to mean equal to or greater than X and equal to or less than Y.

In an embodiment, the wiring board 1 may include a first face 11, a second face 12, an insulating substrate 10, a first wiring conductor 21 located on the first face 11, a second wiring conductor 23 located on the second face 12, and a third wiring conductor 25. The second face 12 may be located opposite to the first face 11. The insulating substrate 10 may include a through portion 13 extending from the first face 11 to the second face 12. The third wiring conductor 25 may be located in the through portion 13. The third wiring conductor 25 may extend from a first opening 13a of the through portion 13 that is adjacent to the first face 11 to a second opening 13b of the through portion 13 that is adjacent to the second face 12. The third wiring conductor 25 may be electrically connected to the first wiring conductor 21 and the second wiring conductor 23. In other words, the third wiring conductor 25 may be a through-via conductor.

The insulating substrate 10 may be a ceramic containing aluminum nitride as a main component. The main component refers to a component having the highest content, and may be a component contained in an amount of 80 mass% or more. The insulating substrate 10 may contain, as a main component, silicon nitride, aluminum oxide, silicon carbide, or zirconia. The insulating substrate 10 may be so-called glass that is an amorphous solid containing silicate or the like as a main component. The main component of the insulating substrate 10 may be selected depending on the application of the wiring board 1. For example, when aluminum nitride is used as the main component, the wiring board 1 can have good thermal conductivity. When aluminum oxide is used as the main component, the wiring board 1 can be easily reduced in thickness because the wiring board exhibits high rigidity. When silicon nitride is used as the main component, the wiring board 1 can have high toughness.

As indicated by dashed lines in FIG. 2, the through portion 13 has the first opening 13a adjacent to the first face 11 and the second opening 13b adjacent to the second face 12. The third wiring conductor 25 may be located in the through portion 13, the first opening 13a, and the second opening 13b. The through portion 13 includes an inner surface. The inner surface may be perpendicular to the first face 11 and the second face 12. An end of the inner surface of the through portion 13 that is located at the first opening 13a may be a first end adjacent to the first face 11. An end of the inner surface of the through portion 13 that is located at the second opening 13b may be a second end remote from the first face 11. In other words, the third wiring conductor 25 is located continuously from the first end to the second end.

The wiring board 1 may include a blind hole or a groove. The blind hole or groove may include a first opening 13a that opens on the first face 11. The blind hole or groove includes an inner surface. An end of the inner surface of the blind hole or groove that is located at the first opening 13a may be a first end adjacent to the first face 11. An end of the inner surface of the blind hole or groove that is at an innermost part or bottom of the hole or groove may be a second end remote from the first face 11. The blind hole or groove may hold the third wiring conductor 25 having a shape that is the same as and/or similar to that of the through portion 13. The third wiring conductor 25 held in the blind hole or groove opening on the first face 11 may be electrically connected to the first wiring conductor 21 located on the first face 11.

In the following description, the term "hole or groove" is intended to include not only the through portion 13 extending from the first face 11 to the second face 12 but also the blind hole or groove including the first opening 13a opening on the first face 11. Additionally, the term "surface of the insulating substrate 10" is intended to include all of a surface of the first face 11, a surface of the second face 12, the inner surface of the through portion 13, and the inner surface and a bottom surface of the blind hole or groove.

The first wiring conductor 21, the second wiring conductor 23, and the third wiring conductor 25 may include a titanium oxide layer 31, a first conductor layer 32, and a second conductor layer 33. The titanium oxide layer 31 may be in contact with the surface of the insulating substrate 10. The first conductor layer 32 may be in contact with the titanium oxide layer 31. The second conductor layer 33 may be in contact with the first conductor layer 32.

The titanium oxide layer 31 contains titanium oxide. The titanium oxide layer 31 covers portions of the surface of the insulating substrate 10 over which the wiring conductors are located. In particular, in the through portion 13, the titanium oxide layer 31 extends continuously from the first end to the second end of the inner surface. The first conductor layer 32 and the second conductor layer 33 are made of metal. The first conductor layer 32 may be an electroless plating layer. The second conductor layer 33 may be an electroplating layer. Examples of metal used for the first conductor layer 32 and the second conductor layer 33 may include copper, nickel, cobalt, and iron. The metal used for the first conductor layer 32 and the metal used for the second conductor layer 33 may be the same type or different types. For example, copper may be used for the first conductor layer 32, and nickel may be used for the second conductor layer 33.

A first diffusion layer 34 may be located at an interface between the insulating substrate 10 and the titanium oxide layer 31. In an embodiment, the first diffusion layer 34 contains elements diffused from the insulating substrate 10 and the titanium oxide layer 31. The first diffusion layer 34 improves adhesion between the insulating substrate 10 and the titanium oxide layer 31. Furthermore, a second diffusion layer 35 may be located at an interface between the titanium oxide layer 31 and the first conductor layer 32. In an embodiment, the second diffusion layer 35 contains elements diffused from the titanium oxide layer 31 and the first conductor layer 32. The second diffusion layer 35 enhances adhesion between the titanium oxide layer 31 and the first conductor layer 32.

### <Sizes of Metal Crystal Grains>

Each of the first conductor layer 32 and the second conductor layer 33 is a polycrystalline metal including a plurality of metal crystal grains 37 bonded together. FIGs. 2 and 3 schematically illustrate the metal crystal grains 37. Actually, the metal crystal grains 37 have various shapes, such as granular and columnar shapes, and vary in size. In an embodiment, the sizes of the metal crystal grains are cross-sectional dimensions measured using an SEM (scanning electron microscope) and are expressed in units of length.

Since the metal crystal grains 37 have various shapes such as granular and columnar shapes, an average size of the metal crystal grains 37 is obtained as follows. FIG. 3 is a diagram illustrating a method of measuring the sizes of the metal crystal grains. The sizes of the metal crystal grains can be measured in a section including the first conductor layer 32 and the second conductor layer 33 by using an SEM.
1. In an SEM image or an SIM (scanning ion microscope) image of a section including the first conductor layer 32 and the second conductor layer 33, boundary lines (grain boundaries) of the respective metal crystal grains 37 are extracted.
2. Any region having a size that includes 20 to 100 metal crystal grains 37 is selected as a target region R from the above-described image. For example, the target region R may be determined based on boundaries between grains having different sizes in the above-described image. In FIG. 3, the metal crystal grains 37 are simplified, and the number of metal crystal grains 37 in the target region R is different from the actual number of metal crystal grains. Multiple target regions R are selected as measurement targets in each conductor layer.
3. The number of metal crystal grains 37 in each target region R is counted, and the area of the region is divided by the above-described number, thus determining an average cross-sectional area of one metal crystal grain 37. Furthermore, assuming that each metal crystal grain 37 has a circular cross-sectional shape, the diameter of such a circle is calculated from the above-described area, and the diameter is regarded as an average size of the metal crystal grains 37.

The average size of the metal crystal grains 37 in the first conductor layer 32 is smaller than that of the metal crystal grains 37 in the second conductor layer 33. The difference between the average sizes of the metal crystal grains 37 is at a level exceeding a margin of error. The "difference at a level exceeding a margin of error" may refer to a difference that is 1.5 times or more or 2 times or more a standard deviation σ of the sizes of the metal crystal grains 37 measured in any portion.

Since the average size of the metal crystal grains 37 in the first conductor layer 32 is smaller than that in the second conductor layer 33, an effect of improving resistance to electromigration is achieved.

### <Surface Structure>

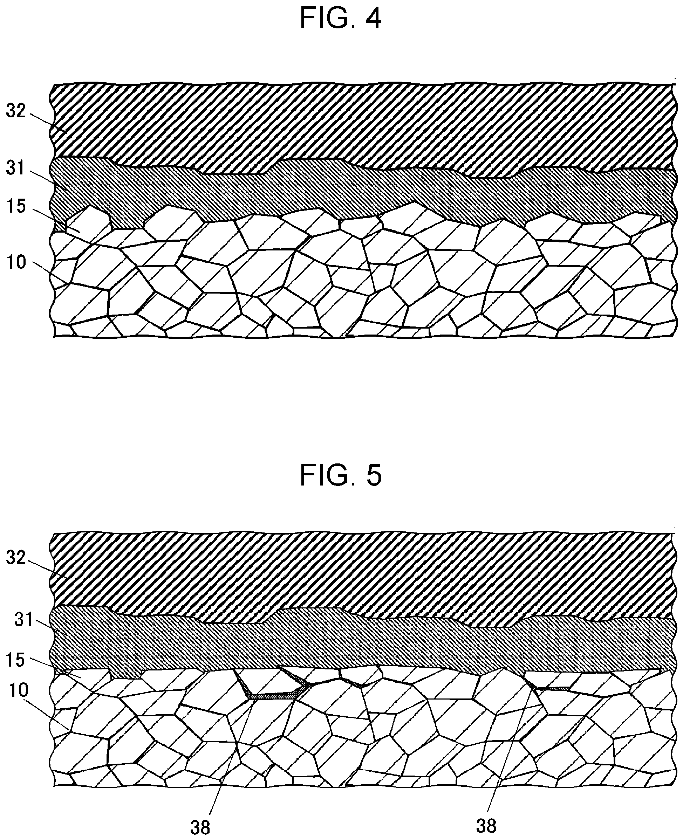

FIGs. 4 and 5 are vertical sectional views of a portion of the wiring board 1 that is located in a region where the first wiring conductor 21, the second wiring conductor 23, and the third wiring conductor 25 are located and that includes the surface of the insulating substrate 10. The insulating substrate 10 may have a structure including a plurality of particles 15 sintered and densified. The particles 15 may vary in shape. Therefore, the surface of the insulating substrate 10 includes irregularities caused by the shapes and arrangement of the particles 15. In other words, the surface of the insulating substrate 10 includes recesses and protrusions.

The titanium oxide layer 31 is located to cover the irregularities located on the surface of the insulating substrate 10. This means that the titanium oxide layer 31 extends continuously on the recesses and the protrusions located on the surface of the insulating substrate 10. It also means that the titanium oxide layer 31 extends continuously along the irregularities located on the surface of the insulating substrate 10. Furthermore, it also means that no portion of the surface of the insulating substrate 10 is exposed through the titanium oxide layer 31 and that the titanium oxide layer 31 extends continuously without interruption.

Since the titanium oxide layer 31 is located in the above-described manner, the first conductor layer 32 extending along the titanium oxide layer 31 extends continuously within the wiring conductors. Furthermore, the second conductor layer 33 extending along the first conductor layer 32 also extends continuously within the wiring conductors. Therefore, the first wiring conductor 21, the second wiring conductor 23, and the third wiring conductor 25 contain no voids. This can reduce the occurrence of defects in the wiring board 1.

A surface condition of the insulating substrate 10 varies depending on, for example, a material of the insulating substrate 10 and a step of pretreatment for the insulating substrate 10 that is performed before the titanium oxide layer 31 is provided. FIG. 4 illustrates a surface condition of the insulating substrate 10 in which surface particles have fallen off along grain boundaries, which are boundaries of the particles 15 sintered and densified. In other words, most of the particles 15 located at the surface of the insulating substrate 10 maintain their shapes formed upon sintering and densification, and surfaces of the particles 15 that serve as the grain boundaries are in contact with the titanium oxide layer 31. The particles 15 located at the surface and the particles 15 adjacent thereto have few or no gaps 38 therebetween. An arithmetic mean height Sa, which is a parameter representing a surface roughness, falls within a range from 0.3 µm to 1.3 µm. Such a surface condition is often observed, for example, when the pretreatment includes a step of dissolving the surface of the insulating substrate 10 containing aluminum nitride as a main component.

FIG. 5 illustrates a surface condition of the insulating substrate 10 in which surface-layer particles 15 have been abraded to provide a smooth surface. Although the surface of the insulating substrate 10 includes irregularities caused by the shapes and arrangement of the particles 15, the surface is smoother and includes fewer irregularities than the surface illustrated in FIG. 4. In other words, the shapes of some of the particles 15 located at the surface of the insulating substrate 10 are smaller than those formed upon sintering and densification, and surfaces of some of the particles 15 that were not grain boundaries are in contact with the titanium oxide layer 31. Additionally, the surface-layer particles 15 and the particles 15 adjacent thereto have gaps 38 therebetween. The number of gaps 38 is greater than that in the surface condition of the insulating substrate 10 illustrated in FIG. 4. Such a surface condition is often observed, for example, when the pretreatment includes a step of polishing the surface of the insulating substrate 10.

In an embodiment of the present disclosure, the wiring board 1 is configured such that the titanium oxide layer 31 continuously covers the surface of the insulating substrate 10, regardless of differences in the surface conditions of the insulating substrate 10 illustrated in FIGs. 4 and 5. In other words, the titanium oxide layer 31 continuously covers the surface of the insulating substrate 10, irrespective of the surface roughness of the insulating substrate 10. The irregularities caused by the shapes and arrangement of the particles 15 on the surface of the insulating substrate 10 provide an anchor effect, thus enhancing stable adhesion of the titanium oxide layer 31. In particular, the surface condition illustrated in FIG. 4 is rougher than the surface condition illustrated in FIG. 5 and includes fewer gaps 38 between the particles 15, and therefore provides further enhanced stable adhesion of the titanium oxide layer 31.

The titanium oxide layer 31 may continuously cover the surface of a single insulating substrate 10 having different surface conditions. For example, in the configuration illustrated in FIG. 2, when the first face 11, the second face 12, and the through portion 13 of the insulating substrate 10 have different surface conditions, the titanium oxide layer 31 may continuously cover the surface of the insulating substrate 10. In other words, when the first face 11 and the second face 12 have the surface condition illustrated in FIG. 5 and the through portion 13 has the surface condition illustrated in FIG. 4, the titanium oxide layer 31 may continuously cover the surface of the insulating substrate 10.

### <Structure of Hole or Groove>

The relationship between the depth of a hole or a groove and the width of an opening thereof can be expressed by an aspect ratio. The aspect ratio of the hole or groove is calculated using the following equation: the aspect ratio = (the depth of the hole or groove) / (the width of the opening of the hole or groove). The depth of a blind hole or a groove is defined as a distance from an opening to the innermost part or bottom of the hole or groove. The depth of a through-hole like the through portion 13 is defined as a distance from the first opening 13a to the second opening 13b, which is opposite the first opening 13a. The width of the opening of the hole or groove is defined as the diameter of a circle when the opening is circular. When the opening is not circular, the width of the opening of the hole or groove is defined as the length of the shortest straight line of straight lines passing through the center of the opening and connecting opposite ends or sides of the opening. In other words, the width of the opening of the hole or groove is defined as the width of the narrowest part of the opening.

A higher aspect ratio makes it more difficult to form the titanium oxide layer 31 on the inner surface of the hole or groove. For the aspect ratio of the hole or groove included in the insulating substrate 10, the aspect ratio of the through-hole preferably ranges from 1 to 8, more preferably from 2 to 6. The aspect ratio of the blind hole or groove preferably ranges from 0.5 to 4, more preferably from 1 to 3.

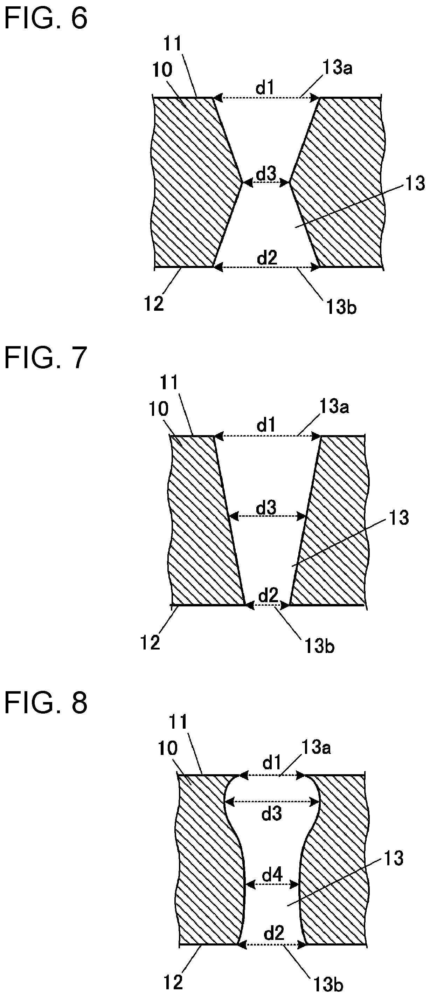

The inner surface of the hole or groove is not limited to being perpendicular to the first face 11 and the second face 12 as illustrated in FIG. 1, and may have another shape. FIGs. 6 to 8 illustrate example sectional shapes of the through portion 13. The width of an inner part of the through portion 13 may be narrower than the width of the first opening 13a and that of the second opening 13b. FIG. 6 illustrates the through portion 13 shaped such that its width gradually decreases toward the middle of the through portion 13 from both the first opening 13a and the second opening 13b. In other words, the through portion 13 includes a part having a diameter d3 that is smaller than a diameter d1 of the first opening 13a and a diameter d2 of the second opening 13b. FIG. 7 illustrates the through portion 13 shaped such that its width gradually decreases from the first opening 13a to the second opening 13b. In other words, the diameter d3 of each part of the through portion 13 is smaller than the diameter d1 of the first opening 13a and is larger than the diameter d2 of the second opening 13b. In other words, FIGs. 6 and 7 each illustrate a hole shape having an inside diameter smaller than the diameter of at least one opening. The shape illustrated in FIG. 6 is often observed in a case where the through portion 13 is formed by performing a blasting process from the first face 11 side and from the second face 12 side of the insulating substrate 10. The shape illustrated in FIG. 7 is often observed when the through portion 13 is formed by performing a laser machining process from the first face 11 side of the insulating substrate 10.

The width of the inner part of the through portion 13 may be wider than the width of each opening. FIG. 8 illustrates the through portion 13 including a diameter-enlarged part having a diameter d3 larger than the diameter d1 of the first opening 13a and the diameter d2 of the second opening 13b. Although the diameter-enlarged part is located adjacent to the first opening 13a, the position of the diameter-enlarged part is not limited to this example. The diameter-enlarged part may be located at the middle of the through portion 13 or may be located adjacent to the second opening 13b. Additionally, the width of the through portion 13 gradually increases from the middle of the through portion 13 toward the second opening 13b. In other words, the through portion 13 includes a diameter-reduced part having a diameter d4 smaller than the diameter d2 of the second opening 13b. The diameter d4 of the diameter-reduced part and the diameter d1 of the first opening 13a may be the same or may differ from each other.

In other words, FIG. 8 illustrates the shape of the hole including a part having an inside diameter larger than the diameters of both the openings. Each of the shapes of FIGs. 1 and 8 may be regarded as having a region that does not intersect a straight line passing through the first opening 13a or the second opening 13b and extending in a depth direction of the hole or groove. Additionally, each of the shapes of FIGs. 1 and 8 may be regarded as having a region that does not intersect a straight line passing through the first opening 13a or the second opening 13b and perpendicular to the first face 11 or the second face 12. The shapes of FIGs. 1 and 8 are often observed when the through portion 13 is formed by punching a green sheet, which is in an unsintered state, from the first face 11 side.

The present disclosure is applicable to the through portion 13 having any shape. In other words, the titanium oxide layer 31 continuously covers the inner surface of the through portion 13 having any of the above shapes from the first opening 13a to the second opening 13b, the inner surface serving as the surface of the insulating substrate 10. The width of the inner part of the blind hole or groove may also be narrower or wider than the width of the opening thereof. Examples of such a shape include shapes having sections like those illustrated in FIGs. 1, 6, 7, and 8 in each of which one opening is closed. The titanium oxide layer 31 continuously covers the inner surface and the bottom surface of the blind hole or groove having such a shape, the inner surface and the bottom surface serving as the surface of the insulating substrate 10. This enables the first conductor layer 32 and the second conductor layer 33 to extend continuously within the wiring conductors, irrespective of the shape of the hole or groove.

### <Thickness of Titanium Oxide Layer>

The titanium oxide layer 31 has a thickness of preferably from 10 nm to 80 nm, more preferably from 20 nm to 60 nm. A small thickness of the titanium oxide layer 31 allows the titanium oxide layer 31 to be used in fine structures. The titanium oxide layer 31 having a thickness that falls within the above-described range can be located uniformly in the hole or groove, thus forming the wiring conductors without portions where the titanium oxide layer 31 is thicker than necessary.

It is preferred that the thickness of the titanium oxide layer 31 on the first face 11 or the second face 12 be within a range from 20 nm to 60 nm. The titanium oxide layer 31 having a thickness that falls within the above-described range on the first face 11 or the second face 12 can be easily removed by etching.

In an embodiment, the titanium oxide layer may be formed by applying an organic titanate to the surface of the insulating substrate 10 and then oxidizing the applied organic titanate. In this case, in an embodiment of the present disclosure, the wiring board 1 can be manufactured more efficiently than in a case where a titanium-containing layer is formed by other means such as sputtering. For example, such a method of forming the titanium oxide layer enables a titanium-containing film to be formed uniformly on the surface of the insulating substrate 10, including the inner surface of the hole or the inner and bottom surfaces of the groove. Thus, the titanium oxide layer 31 covers the irregularities caused by the shapes and arrangement of the particles located at the surface of the insulating substrate 10. The titanium oxide layer 31 is located continuously from the first end, which is adjacent to the first face 11, of the inner surface of the hole or groove to the second end thereof remote from the first face 11. This allows the first conductor layer 32 and the second conductor layer 33 to extend continuously from the first end to the second end, thus providing the third wiring conductor 25 without voids. In the case where the hole or groove includes a surface that does not intersect a straight line passing through the first opening 13a or the second opening 13b and extending in the depth direction of the hole or groove as illustrated in FIGs. 1 and 8, the titanium oxide layer 31 can be easily formed by using the above-described forming method. Furthermore, since titanium exists as titanium oxide having no electrical conductivity, it is easier to take measures against the risk of short circuits as compared with a case where titanium exists in an electrically conductive state.

### <Electronic Device and Electronic Module>

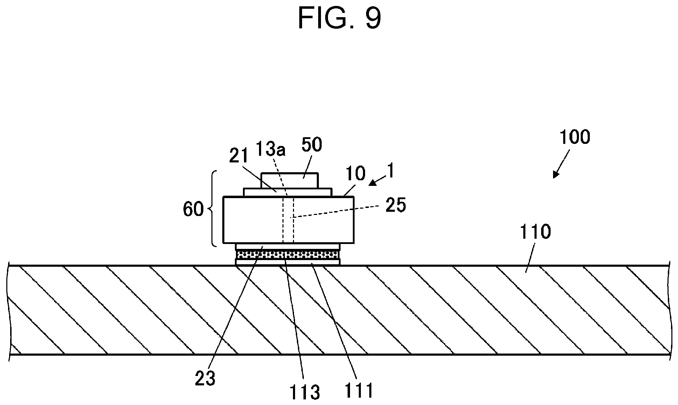

FIG. 9 is a sectional view of an electronic device and an electronic module according to an embodiment of the present disclosure. In an embodiment, an electronic device 60 includes the wiring board 1 on which an electronic component 50 is mounted. The electronic component 50 includes a terminal connected to the first wiring conductor 21. The terminal may be in electrical communication with the second wiring conductor 23 on the second face 12 via the first wiring conductor 21 and the third wiring conductor 25. The first wiring conductor 21 and the second wiring conductor 23 may be coated with a Ni film.

The electronic component 50 may be implemented by, or may include, various electronic components, including optical elements such as an LD (laser diode), a PD (photodiode), and an LED (light-emitting diode), imaging elements such as a CCD (charge-coupled device) imaging element and a CMOS (complementary metal oxide semiconductor) imaging element, piezoelectric vibrators such as a crystal oscillator, surface acoustic wave elements, semiconductor elements such as a semiconductor IC (integrated circuit) element, capacitive elements, inductor elements, and resistors. In particular, when the insulating substrate 10 includes aluminum nitride as a main component, the wiring board 1 can have excellent thermal conductivity, and therefore can be suitably used as a wiring board for vehicle-mounted LED headlights, industrial lasers, and the like.

In an embodiment, an electronic module 100 includes a module substrate 110 on which the electronic device 60 is mounted. In addition to the electronic device 60, another electronic device, an electronic element, an electrical element, and the like may be mounted on the module substrate 110. An electrode pad 111 may be provided on the module substrate 110. The second wiring conductor 23 of the electronic device 60 may be joined to the electrode pad 111 by a bonding material 113 such as solder.

The embodiments of the present disclosure have been described above. However, the configurations of the wiring board 1, the electronic device 60, and the electronic module 100 are not limited to those in the above-described embodiments of the present disclosure. For example, the above embodiment has described the configuration in which the first wiring conductor 21 and the second wiring conductor 23 are exposed on an outer surface of the wiring board 1 and the third wiring conductor 25 is located between the two wiring conductors exposed on the outer surface of the wiring board 1. The wiring conductors may be wiring layers located in a multi-layer wiring board, and the third wiring conductor 25 may be an interlayer via in the multi-layer wiring board. The third wiring conductor 25 may be a conductor that defines a through-hole or a conductor that defines a castellated hole. According to the present disclosure, the occurrence of defects in the wiring board 1, as well as in the electronic device 60 and the electronic module 100 each including the wiring board 1, can be reduced.

In an embodiment, (1) a wiring board includes:
an insulating substrate including a first face and a hole or a groove opening on the first face;
a titanium oxide layer located in the hole or the groove of the insulating substrate; and
a conductor layer located on the titanium oxide layer,
the hole or the groove including an inner surface,
the inner surface including a first end adjacent to the first face and a second end remote from the first face,
the titanium oxide layer being located continuously from the first end to the second end of the inner surface.

(2) A wiring board includes:
an insulating substrate containing aluminum nitride as a main component and including a plurality of particles bonded together;
a titanium oxide layer located on a surface of the insulating substrate; and
a conductor layer located on the titanium oxide layer,
the surface of the insulating substrate including irregularities caused by shapes and arrangement of the plurality of particles,
the titanium oxide layer covering the irregularities.

(3) In the wiring board according to (2),
the insulating substrate may include a first face and a hole or a groove opening on the first face,
the hole or the groove may include an inner surface serving as a portion of the surface,
the inner surface may include a first end adjacent to the first face and a second end remote from the first face, and
the titanium oxide layer may be located continuously from the first end to the second end of the inner surface.

(4) In the wiring board according to any one of (1) to (3),
the titanium oxide layer may be located throughout the inner surface.

(5) In the wiring board according to any one of (1) to (4),
the insulating substrate may include a second face opposite the first face, and
the hole may be a through-hole extending from the first face to the second face.

(6) The wiring board according to any one of (1) to (5) may further include:
a first diffusion layer at an interface between the titanium oxide layer and the insulating substrate,
the first diffusion layer containing elements diffused from the titanium oxide layer and the insulating substrate.

(7) The wiring board according to any one of (1) to (6) may further include:
a second diffusion layer at an interface between the titanium oxide layer and the conductor layer,
the second diffusion layer containing elements diffused from the titanium oxide layer and the conductor layer.

(8) In the wiring board according to any one of (1) to (7),
the conductor layer may be made of metal and include
   a first conductor layer in contact with the titanium oxide layer and
   a second conductor layer located on an opposite side of the first conductor layer from the titanium oxide layer,
the first conductor layer including metal crystal grains having an average size smaller than an average size of metal crystal grains included in the second conductor layer.

(9) In the wiring board according to any one of (1) to (8),
the first conductor layer may be an electroless plating layer, and
the second conductor layer may be an electroplating layer.

(10) An electronic device may include:
the wiring board according to any one of (1) to (9); and
an electronic component mounted on the wiring board.

(11) An electronic module may include:
the electronic device according to (10); and
a module substrate on which the electronic device is mounted.

### INDUSTRIAL APPLICABILITY

The present disclosure is applicable to a wiring board, an electronic device, and an electronic module.

### REFERENCE SIGNS

- 1: wiring board
- 10: insulating substrate
- 11: first face
- 12: second face
- 13: through portion
- 13a: first opening
- 13b: second opening
- 15: particle
- 31: titanium oxide layer
- 32: first conductor layer
- 33: second conductor layer
- 34: first diffusion layer
- 35: second diffusion layer
- 50: electronic component
- 60: electronic device
- 100: electronic module

## Claims

1. A wiring board comprising:
an insulating substrate containing aluminum nitride as a main component and comprising a plurality of particles bonded together;
a titanium oxide layer located on a surface of the insulating substate; and
a conductor layer located on the titanium oxide layer, wherein
the surface of the insulating substrate includes irregularities caused by shapes and arrangement of the particles, and
the titanium oxide layer covers the irregularities.

2. The wiring board according to claim 1, wherein
the insulating substrate includes a first face and a hole or a groove opening on the first face,
the hole or the groove includes an inner surface serving as a portion of the surface,
the inner surface includes a first end adjacent to the first face and a second end remote from the first face, and
the titanium oxide layer is located continuously from the first end to the second end of the inner surface.

3. The wiring board according to claim 2, wherein the titanium oxide layer is located throughout the inner surface.

4. The wiring board according to claim 2 or 3, wherein
the insulating substrate includes a second face opposite the first face, and
the hole is a through-hole extending from the first face to the second face.

5. The wiring board according to any one of claims 1 to 4, further comprising:
a first diffusion layer at an interface between the titanium oxide layer and the insulating substrate, wherein
the first diffusion layer contains elements diffused from the titanium oxide layer and the insulating substrate.

6. The wiring board according to any one of claims 1 to 5, further comprising:
a second diffusion layer at an interface between the titanium oxide layer and the conductor layer, wherein
the second diffusion layer contains elements diffused from the titanium oxide layer and the conductor layer.

7. The wiring board according to any one of claims 1 to 6, wherein
the conductor layer comprises metal and includes:
a first conductor layer in contact with the titanium oxide layer; and
a second conductor layer located on an opposite side of the first conductor layer from the titanium oxide layer, and
the first conductor layer includes metal crystal grains having an average size smaller than an average size of metal crystal grains included in the second conductor layer.

8. The wiring board according to claim 7, wherein
the first conductor layer is an electroless plating layer, and
the second conductor layer is an electroplating layer.

9. An electronic device comprising:
the wiring board according to any one of claims 1 to 8; and
an electronic component mounted on the wiring board.

10. An electronic module comprising:
the electronic device according to claim 9; and
a module substrate on which the electronic device is mounted.
